# EUROPEAN PATENT SPECIFICATION

(11) **EP 1 281 519 B1**
(45) Date of publication and mention of the grant of the patent: **07.03.2007**
(21) Application number: 02016674.0
(22) Date of filing: 25.07.2002
(51) Int. Cl.: B41F 15/42, H05K 3/12

(54) **Method of charging hole with fluid material**
Verfahren zum Laden von Löchern mit flüssigem Material
Procédé de chargement d'un trou avec matière fluide

(30) Priority: 31.07.2001 JP 2001232532
(43) Date of publication of application: 05.02.2003
(73) Proprietor: DENSO CORPORATION, Kariya-city, Aichi-pref., 448-0029 (JP)
(72) Inventor: Morita, Hiromichi, c/o Denso Corporation, Kariya-city, Aichi-pref. 448-0029 (JP); Kojima, Fumio, c/o Denso Corporation, Kariya-city, Aichi-pref. 448-0029 (JP); Kitamura, Nobuyuki, c/o Denso Corporation, Kariya-city, Aichi-pref. 448-0029 (JP)
(74) Representative: Winter, Brandl, Fürniss, Hübner Röss, Kaiser, Polte Partnerschaft Patent- und Rechtsanwaltskanzlei

(56) References cited:
- US-A- 5 254 362
- PATENT ABSTRACTS OF JAPAN vol. 018, no. 611 (M-1708), 21 November 1994 (1994-11-21) & JP 06 234204 A (MATSUSHITA ELECTRIC IND CO LTD), 23 August 1994 (1994-08-23)

## Description

### Field of the Invention

This invention generally relates to a method of charging a hole with fluid material. This invention specifically relates to a method of charging a hole in a substrate with fluid material such as electrically conductive paste.

### Description of the Related Art

An insulating substrate forming a printed wiring board has via holes. It is known to use screen printing to charge via holes with electrically conductive paste being a mixture of metal particles, an organic solvent, and binder resin.

The screen printing has the following sequence of steps. First, a screen sheet is place above an insulating substrate having via holes. The screen sheet has a pattern of open areas positionally corresponding to the via holes. Electrically conductive paste is applied onto the screen sheet. Subsequently, the electrically conductive paste is transferred across the screen sheet by a squeegee while the squeegee is pressed against the screen sheet. At this time, the squeegee is moved linearly only in one direction or linearly reciprocated along two opposite directions. The squeegee forces the electrically conductive paste into the via holes through the open areas of the screen sheet.

As the via holes are smaller in diameter, the screen printing tends to insufficiently charge the via holes with the electrically conductive paste. The inventors of this invention have found that the 1-direction movement or the 2-direction reciprocating movement of the squeegee causes the electrically conductive material to be unevenly distributed in the via holes. The uneven distributions mean insufficiently charging the via holes with the electrically conductive paste.

Japanese patent application publication number 06-234204 discloses a screen printing device for cream solder which is capable of transferring the cream solder on a printed wiring board while kneading the cream solder sufficiently and forcing the same into the pattern holes of a mask plate. The screen printing device includes a squeegee sliding on the mask plate. The squeegee has a cylinder containing the cream solder. The squeegee is moved along an X direction or a Y direction while being rotated in a horizontal plane. The squeegee charges the pattern holes with the cream solder, and transfers the cream solder onto the printed wiring board.

United States Patent Number 5,254,362 corresponding to Japanese patent application publication number 7-68730 discloses a method and apparatus for uniformly depositing solder paste on a printed wiring board which are designed so that a squeegee arrangement applies the solder paste through a stencil to a surface of the printed wiring board. As the squeegee assembly is moved in one planar direction over the stencil in a planar fashion, it is also vibrated by a vibrator to produce slight circular motion in addition to the planar motion of the squeegee blade.

Japanese patent application publication number P2000-117937A discloses a screen printing machine capable of forming a paste pattern on a substrate by pressing a head onto the substrate at a force chosen not to add an injury onto the substrate even in the case where a pattern aperture part is small. The head is filled with paste. The head is pushed vertically against a main surface of the substrate via a mask having the pattern aperture part. The head is relatively moved in a direction parallel to the main surface of the substrate or the mask while the paste is discharged from an outlet opening of the head. As a result, a paste pattern is printed on the substrate through the pattern aperture part of the mask. During the relative movement of the head, at least one among the head, the mask, and the substrate is reciprocated.

Japanese patent application publication number 11-77957 discloses solder paste printing method and apparatus designed so that a squeegee is circularly moved, and hence part pads arranged in any directions can be sufficiently supplied with solder paste. The squeegee is placed on a printing jig having paste feed openings. The squeegee serves to spread the solder paste discharged from the paste feed openings in the printing jig. The solder paste is supplied from the paste feed openings to the part pads on a substrate while the squeegee is circularly moved.

Japanese patent application publication number 3-93288 discloses a screen printing apparatus for a circuit pattern which is designed so that a squeegee device can be slid on a screen mask along a prescribed direction (a sliding direction). When paste or solder cream clogs or blurs due to the directivity of pattern holes in the screen mask, the squeegee device is horizontally rotated to change its orientation relative to the sliding direction. The orientation change enhances the degree of charging the pattern holes with the paste or solder cream.

### SUMMARY OF THE INVENTION

It is an object of this invention to provide a reliable method of charging a hole with fluid material.

The object is solved by the features of the independent claims. The dependent claims are directed to preferred embodiments of the invention.

### BRIEF DESCRIPTION OF THE DRAWINGS

Fig. 1 is a perspective diagram of a charging apparatus according to a first embodiment of this invention.
Figs. 2-8 are sectional views of a film or films in conditions occurring at different stages in the fabrication of a printed wiring board which includes a step of charging via holes with electrically conductive paste according to the first embodiment of this invention.
Fig. 9 is a longitudinal section view of a rotary head in Fig. 1.
Fig. 10 is an enlarged view of a portion "A" in Fig. 9.
Fig. 11 is a plan diagram of the rotary head, a single-sided conductor-pattern film, and a trajectory described by the central axis of the rotary head in the first embodiment of this invention.
Fig. 12 is a perspective diagram of a portion of a single-sided conductor-pattern film, a via hole therein, and directions along which electrically conductive paste is forced into the via hole in the first embodiment of this invention.
Fig. 13 is a plan diagram of a rotary head and a single-sided conductor-pattern film in a third embodiment of this invention.
Fig. 14 is a plan diagram of a rotary head, a single-sided conductor-pattern film, and a trajectory described by the central axis of the rotary head in a fourth embodiment of this invention.
Fig. 15 is a plan diagram of a rotary head, a single-sided conductor-pattern film, and a trajectory described by the central axis of the rotary head in a fifth embodiment of this invention.
Fig. 16 is a plan diagram of squeegees and a single-sided conductor-pattern film in a sixth embodiment which is not part of this invention.

### DETAILED DESCRIPTION OF THE INVENTION

### First Embodiment

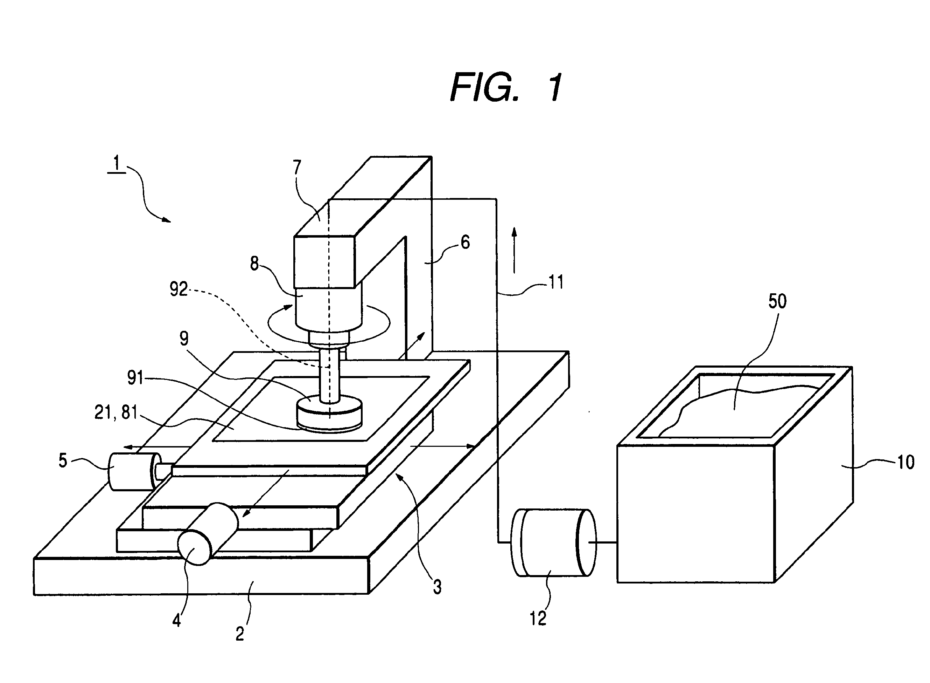

Fig. 1 shows a charging apparatus 1 according to a first embodiment of this invention. The apparatus 1 is designed to charge via holes with electrically conductive paste. The electrically conductive paste is one type of fluid material. The via holes are formed in a resin film being a substrate. The structure of the apparatus 1 will be described later.

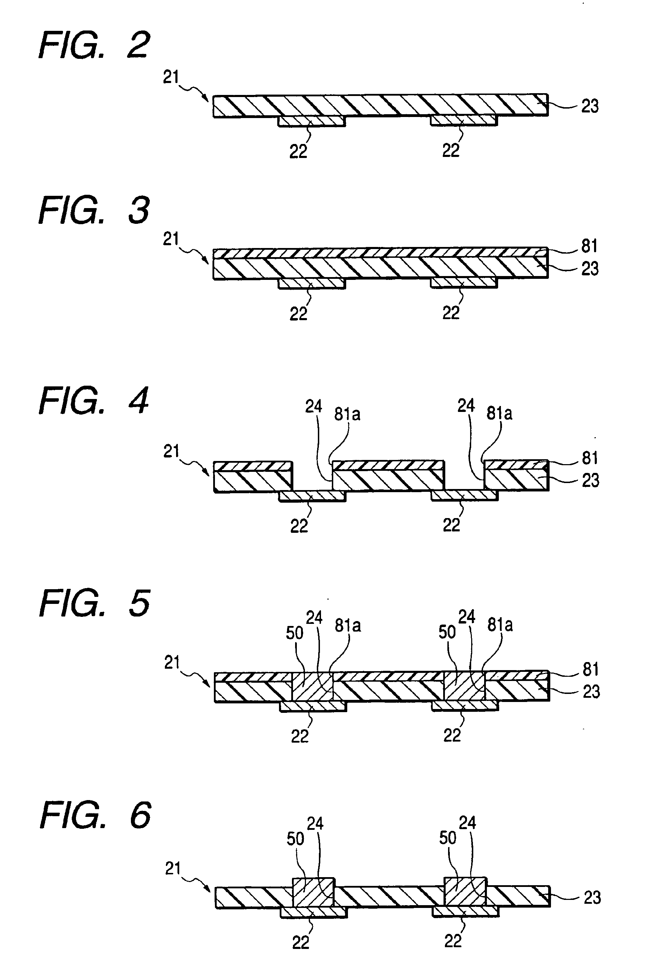

Figs. 2-8 show conditions of a film or films occurring at different stages in the fabrication of a printed circuit board (a printed wiring board) which includes a step of charging via holes with electrically conductive paste according to the first embodiment of this invention. The printed circuit board is made as follows.

With reference to Fig. 2, a single-sided conductor-pattern film 21 is prepared. Specifically, an electrical conductor foil is superposed on and attached to a first surface of a resin film 23. The electrically conductor foil uses, for example, a copper foil having a thickness of 18 µm. The electrically conductor foil is etched into a conductor pattern 22. Therefore, the single-sided conductor-pattern film 21 having the conductor pattern 22 on its first surface is completed. The resin film 23 uses a thermoplastic resin film having a thickness of 25 to 200 µm. The thermoplastic resin film contains 65-35% polyether ether keton resin and 35-65% polyether imide resin by weight.

As shown in Fig. 3, after the conductor pattern 22 is formed on the resin film 23, a protective film 81 is superposed on and attached to a second surface of the resin film 23 by using, for example, a laminator. The second surface of the resin film 23 is opposed to the first surface thereof on which the conductor pattern 22 extends. The protective film 81 uses a polyethylene terephthalate resin film having a thickness of 12 µm and coated with an adhesive layer having a thickness of 5 µm.

As shown in Fig. 4, after the attachment of the protective film 81 is completed, a carbon dioxide laser beam is applied, from above in the drawing, to the protective film 81 and the resin film 23 to form openings (apertures) 81a and via holes 24 therein. The openings 81a in the protective film 81 align with the via holes 24 in the resin film 23. The openings 81a are approximately equal in diameter to the via holes 24. The via holes 24 have bottoms closed by the conductor pattern 22. Thus, the conductor pattern 22 is exposed at the bottoms of the via holes 24. The power and application time of the carbon dioxide laser beam are chosen not to form holes in the conductor pattern 22. The via holes 24 have diameters of 30 to 200 µm.

An excimer laser beam may be used instead of the carbon dioxide laser beam to form the via holes 24. Alternatively, drilling may be used to form the via holes 24.

As shown in Fig. 5, after the via holes 24 are formed, the via holes 24 are charged with electrically conductive paste 50 being inter-layer-connection fluid material. The electrically conductive paste 50 results from kneading metal particles, binder resin, and an organic solvent by a mixer. The metal particles include, for example, copper particles, silver particles, or tin particles. Specifically, the apparatus 1 in Fig. 1 forces the electrically conductive paste 50 into the via holes 24 through the openings 81a in the protective film 81. The electrically conductive paste 50 in the via holes 24 is in contact with the conductor pattern 22. Thus, the electrically conductive paste 50 in the via holes 24 is electrically connected with the conductor pattern 22. Also, the openings 81a in the protective film 81 are filled with the electrically conductive paste 50.

After the via holes 24 are charged with the electrically conductive paste 50, the protective film 81 is exfoliated and removed from the resin film 23 or the single-sided conductor-pattern film 21. Consequently, there occurs the single-sided conductor-pattern film 21 having the via holes 24 which are charged with the electrically conductive film 50 as shown in Fig. 6. The electrically conductive paste 50 which has filled the openings 81a in the protective film 81 remains as projections on the resin film 23 which extend from the electrically conductive paste 50 in the via holes 24.

As understood from the above description, the via holes 24 are charged with the electrically conductive paste 50 while the protective film 81 remains on the resin film 23. Therefore, the protective film 81 prevents the electrically conductive paste 50 from being applied to portions of the resin film 23 except for the via holes 24. Accordingly, the protective film 81 functions as a mask. After the charging is completed, the protective film 81 is removed from the resin film 23.

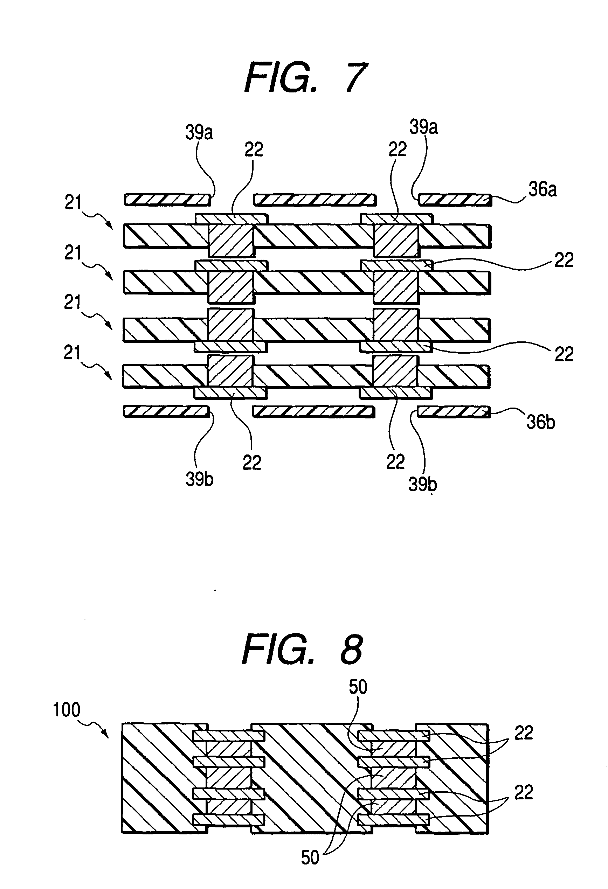

A plurality of single-sided conductor-pattern films 21 each in a state of Fig. 6 and fabricated by the steps in Figs. 2-6 are prepared. As shown in Fig. 7, four single-sided conductor-pattern films 21 are arranged into a laminate in which the conductor patterns 22 on the films 21 vertically align with each other. In the laminate, the conductor pattern 22 on the uppermost film 21 faces upward while the conductor pattern 22 on the lowermost film 21 faces downward. A cover layer 36a is placed at an upper side of the laminate. The cover layer 36a is a resist film extending over portions of the upper surface of the uppermost film 21 which include edges of the conductor pattern 22 on the uppermost film 21. A cover layer 36b is placed at a lower side of the laminate. The cover layer 36b is a resist film extending over portions of the lower surface of the lowermost film 21 which include edges of the conductor pattern 22 on the lowermost film 21.

The cover layer 36a has openings (apertures) 39a positionally corresponding to electrode-forming portions of the conductor pattern 22 on the uppermost film 21. Thus, the electrode-forming portions of the conductor pattern 22 on the uppermost film 21 are exposed via the openings 39a in the cover layer 36a. The openings 39a are formed by, for example, drilling. Similarly, the cover layer 36b has openings (apertures) 39b positionally corresponding to electrode-forming portions of the conductor pattern 22 on the lowermost film 21. Thus, the electrode-forming portions of the conductor pattern 22 on the lowermost film 21 are exposed via the openings 39b in the cover layer 36b. The openings 39b are formed by, for example, drilling. Each of the cover layers 36a and 36b uses a resin film made of the thermoplastic material same as that for the resin film 23. Specifically, each of the cover layers 36a and 36b contains 65-35% polyether ether keton resin and 35-65% polyether imide resin by weight.

The laminate of the single-sided conductor-pattern films 21 and the cover layers 36a and 36b is heated and pressed by a vacuum hot press. Consequently, as shown in Fig. 8, the resin films 23 in the single-sided conductor-pattern films 21, and the cover layers 36a and 36b are bonded together. Specifically, the resin films 23 and the cover layers 36a and 36b are thermally fused into an integral body of insulating material. At the same time, the conductor patterns 22 on the resin films 23 are electrically connected by the electrically conductive paste 50 in the via holes 24. The conductor patterns 22 electrically connected by the electrically conductive paste 50 are supported by the integral body of insulating material. The conductor patterns 22 electrically connected by the electrically conductive paste 50 and the integral body of insulating material compose a multi-layer printed circuit board (a multi-layer printed wiring board) 100.

The apparatus 1 in Fig. 1 will be described below in more detail. As shown in Fig. 1, the apparatus 100 includes a base 2 and a table 3. The table 3 is movably located on the base 2. A single-sided conductor-pattern film 21 having a protective film 81 and via holes 24 as shown in Fig. 4 is placed and supported on the upper surface of the table 3.

An X-axis servo motor 4 and a Y-axis servo motor 5 are mechanically connected with the table 3. The X-axis servo motor 4 functions to move the table 3 along an X-axis direction in a horizontal plane. The Y-axis servo motor 5 functions to move the table 3 along a Y-axis direction in the horizontal plane. The X-axis direction and the Y-axis direction are perpendicular to each other. The X-axis servo motor 4 and the Y-axis servo motor 5 enable the table 3 to assume any position in the horizontal plane. The table 3 may be a known X-Y table.

A vertically-extending stand 6 is provided on one edge portion of the base 2. The stand 6 has an upper end provided with a head support arm 7. The head support arm 7 horizontally projects from the stand 6, and occupies a region above the table 3. A spindle motor 8 is provided on the lower surface of a distal end of the head support arm 7.

The spindle motor 8 has a rotatable shaft coupled with a rotary head 9 which functions as a forcing means. As the shaft of the spindle motor 8 rotates, the rotary head 9 rotates about its central axis. The central axis of the rotary head 9 is approximately perpendicular to the upper surface of the single-sided conductor-pattern film 21 placed on the table 3. The rotary head 9 has a lower end surface provided with a pad member 91 which functions as a forcing member. The pad member 91 faces the upper surface of the single-sided conductor-pattern film 21 placed on the table 3.

The apparatus 1 includes a paste tank 10 containing electrically conductive paste 50 and located near the base 2. The paste tank 10 and the head support arm 7 are connected by a feed pipe 11. A feed passage 92 leading from the interior of an end of the feed pipe 11 extends through the head support arm 7, the shaft of the spindle motor 8, and the rotary head 9.

A pump 12 is provided in a mid point of the feed pipe 11. The pump 12 drives the electrically conductive paste 50 from the paste tank 10 toward the rotary head 9 via the feed pile 11 and the feed passage 92 when being activated.

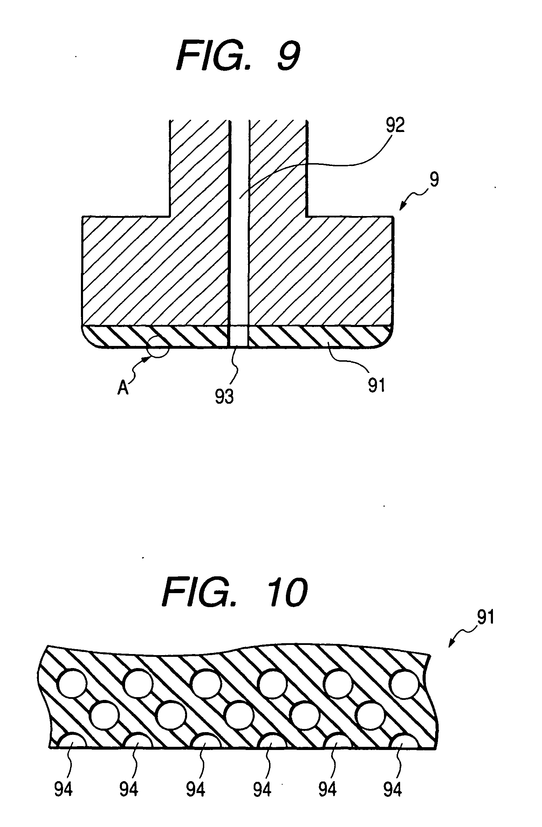

As shown in Fig. 9, the pad member 91 extends over the lower end face of the rotary head 9. A central part of the pad member 91 has an opening 93 which forms an outlet end of the feed passage 92. When the pump 12 is activated, the electrically conductive paste 50 is moved along the feed passage 92 and is discharged from the opening 93.

With reference to Fig. 10, the pad member 91 is made of urethane foam resin having a lot of independent and separate bubbles. The pad member 91 has a ground lower end surface at which bubbles are exposed. The exposed bubbles form approximately hemispherical recesses 94 in the lower end surface of the pad member 91 which opposes the upper surface of the single-sided conductor-pattern film 21 placed on the table 3.

Operation of the apparatus 1 is as follows. A single-sided conductor-pattern film 21 having a protective film 81 and via holes 24 as shown in Fig. 4 is placed and supported on the upper surface of the table 3 in a fashion such that the surface of the single-sided conductor-pattern film 21 which has the protective film 81 faces upward. The rotary head 9 is set so that the lower surface of the pad member 91 will contact with or substantially contact with the upper surface of the protective film 81 on the single-sided conductor-pattern film 21.

The pump 12 is activated. Thus, the pump 12 drives the electrically conductive paste 50 from the paste tank 10 to the rotary head 9 via the feed pipe 11 and the feed passage 92. The electrically conductive paste 50 is discharged from the opening 93 in the rotary head 9, and is supplied onto the upper surface of the protective film 81 on the single-sided conductor-pattern film 21. Simultaneously with the activation of the pump 12, the spindle motor 8 is activated so that the rotary head 9 is rotated.

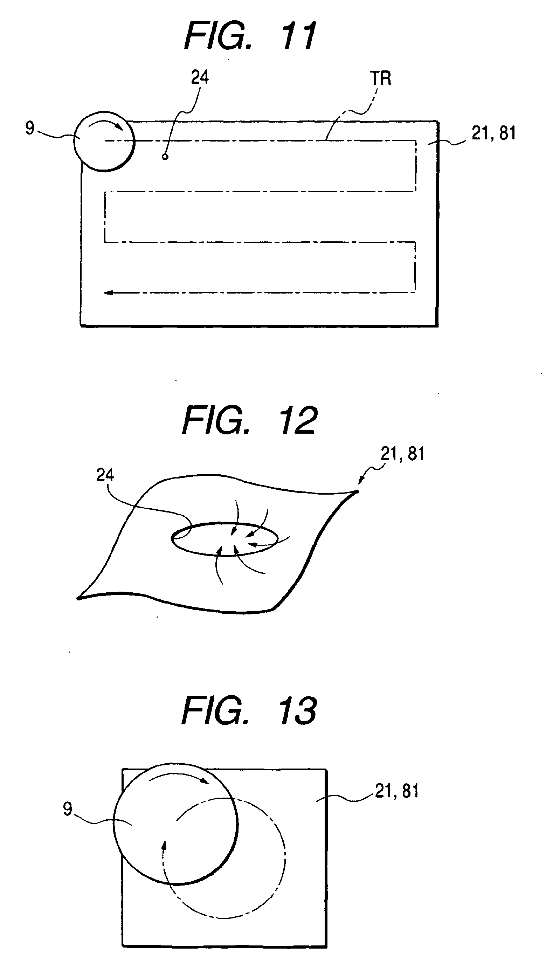

In addition, the X-axis servo motor 4 and the Y-axis servo motor 5 are suitably activated so that the table 3 moves horizontally relative to the rotary head 9. The relative movement of the table 3 is designed to cause the central axis of the rotary head 9 to describe a trajectory TR with respect to the protective film 81 on the single-sided conductor-pattern film 21. As shown in Fig. 11, the trajectory TR is composed of linear segments. Thus, the rotary head 9 linearly moves along the upper surface of the protective film 81 on the single-sided conductor-pattern film 21 while rotating about its central axis. The speed of rotation of the rotary head 9 is set to, for example, 60 rpm. The speed of linear movement of the rotary head 9 is set to, for example, 1 mm/sec.

Preferably, there is a clearance between the pad member 91 on the rotary head 9 and the protective film 81 on the single-sided conductor-pattern film 21. The clearance allows the electrically conductive paste 50, which has been discharged from the opening 93, to spread over the whole of the lower end surface of the pad member 91. The clearance has a thickness (or a width) of, for example, 50-100 µm.

The positional relation between the pad member 91 on the rotary head 9 and the protective film 81 on the single-sided conductor-pattern film 21 may be periodically alternated between a first condition where a clearance exists between the pad member 91 and the protective film 81 and a second condition where the pad member 91 and the protective member 81 are in contact without any clearance therebetween.

With reference to Figs. 11 and 12, since the rotary head 9 linearly moves through a region above a via hole 24 in the single-sided conductor-pattern film 21 while rotating about its central axis, the pad member 91 forces the electrically conductive paste 50 into the via hole 25 along many different directions (at least three different directions).

The electrically conductive paste 50 which has been discharged from the opening 93 spreads over the whole of the lower end surface of the pad member 91. At that time, portions of the electrically conductive paste 50 enter recesses 94 (see Fig. 10) in the lower end surface of the pad member 91. The portions of the electrically conductive paste 50 are held in the recesses 94. Accordingly, the whole of the lower end surface of the pad member 91 can be effectively used in forcing the electrically conductive paste 50 into via holes 24. The electrically conductive paste 50 can be moved from the recesses 94 into the via holes 24.

It should be noted that only one via hole 24 is shown in Fig. 11, and the illustration of other via holes 24 is omitted therefrom.

Preferably, the trajectory TR described by the central axis of the rotary head 9 is separate from via holes 24.

The surface of a conductor pattern 22 which is exposed at the bottoms of via holes 24 may be slightly processed by etching or reduction before the apparatus 1 charges the via holes 24 with the electrically conductive paste 50. This processing improves the performances of inter-layer-connection.

During the operation of the apparatus 1, the rotary head 9 functions as a means for forcing the electrically conductive paste 50 into the via holes 24 in the single-sided conductor-pattern film 21. At that time, the rotary head 9 linearly moves in accordance with the motion of the table 3 while rotating about its central axis. Thus, on the upper surface of the protective film 81 of the single-sided conductor-pattern film 21, the rotary head 9 forces the electrically conductive paste 50 into the via holes 24 along many different directions (at least three different directions). Accordingly, it is possible to prevent the electrically conductive paste 50 from being unevenly distributed in the via holes 24. Furthermore, it is possible to prevent the via holes 24 from being insufficiently charged with the electrically conductive paste 50.

### Second Embodiment

A second embodiment of this invention is similar to the first embodiment thereof except for design changes mentioned hereafter. In the second embodiment of this invention, at least two of (1) rotation of the rotary head 9 about its central axis, (2) linear movement of the rotary head 9, and (3) revolution of the rotary head 9 about an axis separate from its central axis are simultaneously executed. Thus, the rotary head 9 is rotated about its central axis or an axis separate from its central axis while the axis of rotation of the rotary head 9 is moved.

### Third Embodiment

A third embodiment of this invention is similar to the first embodiment thereof except for design changes mentioned hereafter. In the third embodiment of this invention, as shown in Fig. 13, the rotary head 9 is rotated about its central axis while being revolved about an axis separate from its central axis. It should be noted that the illustration of the via holes 24 is omitted from Fig. 13.

### Fourth Embodiment

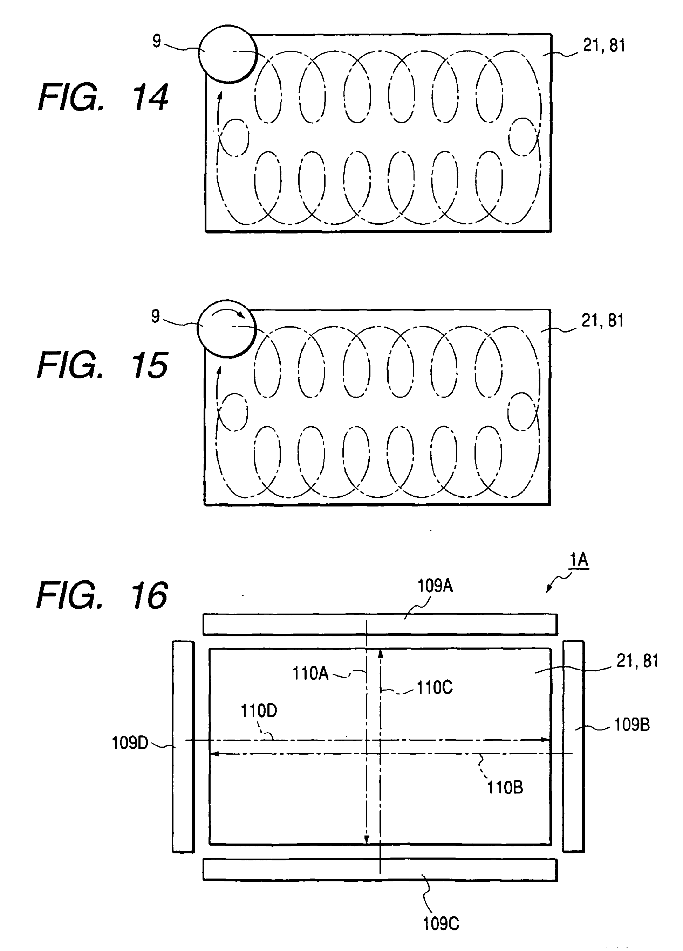

A fourth embodiment of this invention is similar to the first embodiment thereof except for design changes mentioned hereafter. In the fourth embodiment of this invention, as shown in Fig. 14, the rotary head 9 is moved linearly while being revolved about an axis separate from its central axis. It should be noted that the illustration of the via holes 24 is omitted from Fig. 14.

### Fifth Embodiment

A fifth embodiment of this invention is similar to the first embodiment thereof except for design changes mentioned hereafter. In the fifth embodiment of this invention, as shown in Fig. 15, the rotary head 9 is moved linearly while being rotated about its central axis and being revolved about an axis separate from its central axis. In this case, the rotary head 9 can force the electrically conductive paste 50 into each of the via holes 24 along every direction toward the via hole 24. It should be noted that the illustration of the via holes 24 is omitted from Fig. 15.

### Sixth Embodiment

Fig. 16 shows a portion of a charging apparatus 1A according to a sixth embodiment, which is not part of this invention. The charging apparatus 1A in Fig. 16 is similar to the charging apparatus 1 in Fig. 1 except for design changes mentioned hereafter.

As shown in Fig. 16, the charging apparatus 1A includes squeegees 109A, 109B, 109C, and 109D instead of the rotary head 9 (see Fig. 1). Each of the squeegees 109A, 109B, 109C, and 109D functions as a means for forcing the electrically conductive paste 50 into the via holes 24 in the single-sided conductor-pattern film 21. The squeegees 109A and 109C oppose each other. The squeegees 109B and 109D oppose each other. The squeegees 109A, 109B, 109C, and 109D are moved linearly along the upper surface of the single-sided conductor-pattern film 21 (that is, the upper surface of the protective film 81 on the single-sided conductor-pattern film 21) in directions 110A, 110B, 110C, and 110D respectively. The directions 110A and 110C are opposite to each other. The directions 110B and 110D are opposite to each other. The directions 110A and 110C are perpendicular to the directions 110B and 110D. The squeegees 109A, 109B, 109C, and 109D force the electrically conductive paste 50 into each of the via holes 24 along four different directions corresponding to the directions 110A, 110B, 110C, and 110D. It should be noted that the illustration of the via holes 24 is omitted from Fig. 16.

### Seventh Embodiment

A seventh embodiment of this invention is similar to the first embodiment thereof except for design changes mentioned hereafter. In the seventh embodiment of this invention, each of the recesses 94 in the lower end surface of the pad member 91 has the shape of a slit rather than a hemisphere.

### Eighth Embodiment

An eighth embodiment, which is not part, of this invention, is similar to the first embodiment thereof except for design changes mentioned hereafter. The eighth embodiment of this invention includes a feeding means provided separately of the rotary head 9 which functions as the forcing means. The feeding means supplies the electrically conductive paste 50 onto the upper surface of the single-sided conductor-pattern film 21. Preferably, the feeding means is located at a position in front of the forcing means (the rotary head 9) as viewed in the direction of movement of the forcing means.

### Ninth Embodiment

A ninth embodiment of this invention is similar to the first embodiment thereof except for design changes mentioned hereafter. In the ninth embodiment of this invention, two or more single-sided conductor-pattern films 21 are juxtaposed on the upper surface of the table 3. In this case, the apparatus 1 charges via holes 24 in the single-sided conductor-pattern films 21 with the electrically conductive paste 50.

### Tenth Embodiment

A tenth embodiment of this invention is similar to the first embodiment thereof except for design changes mentioned hereafter. According to the tenth embodiment of this invention, the walls defining the via holes 24 are coated with metal layers by plating, and the apparatus 1 charges inner spaces of the metal layers with fluid material such as liquefied resin. The metal layers in the via holes 24 function to provide electrical connection between the conductor patterns 22 on the single-sided conductor-pattern films 21.

### Eleventh Embodiment

An eleventh embodiment of this invention is similar to the first embodiment thereof except for design changes mentioned hereafter. In the eleventh embodiment of this invention, each of the resin films 23 and the cover layers 36a and 36b uses a film made by adding a non-conductive filler to polyether ether keton resin and polyether imide resin. Alternatively, each of the resin films 23 and the cover layers 36a and 36b may uses a film made of only polyether ether keton or polyether imide.

### Twelfth Embodiment

A twelfth embodiment of this invention is similar to the first embodiment thereof except for design changes mentioned hereafter. In the twelfth embodiment of this invention, each of the resin films 23 and the cover layers 36a and 36b uses a thermoplastic resin film made of polyethylene naphthalate, polyethylene terephthalate, polyether sulfone, thermoplastic polyimide, or liquid-crystal polymer.

Alternatively, each of the resin films 23 and the cover layers 36a and 36b may use a thermosetting resin film made of B-stage epoxy resin, bismaleic triazine, polyphenylene ether, or polyimide.

### Thirteenth Embodiment

A thirteenth embodiment of this invention is similar to the first embodiment thereof except for design changes mentioned hereafter. According to the thirteenth embodiment of this invention, a substrate made of resin or metal has holes, and the apparatus 1 charges the holes with fluid material such as liquefied resin. Preferably, the holes have closed bottoms.

## Claims

1. A method of charging a hole (24) in a substrate (23) with fluid material (50), comprising the steps of:
placing a forcing member (91) having a surface that has recesses (94) and an opening located approximately in a center thereof through which fluid material (50) is supplied so that the surface of the forcing member (91) faces the substrate (23);
supplying the fluid material (50) between the surface of the forcing member (91) and a surface of the substrate (23); and
holding the fluid material (50) in the recesses (94) of the surface of the forcing member (91), moving the fluid material (50) from the recesses (94) of the surface of the forcing member (91) into the hole (24) by rotating the forcing member (91) about an axis perpendicular to the surface of the substrate (23), and moving the axis of rotation of the forcing member (91) along the surface of the substrate (23) to force the fluid material (50) into the hole (24) along at least three different directions on the surface of the substrate (23).

2. A method as recited in claim 1, wherein the rotation of the forcing member (91) comprises one of rotation of the forcing member (91) about its central axis and revolution of the forcing member (91) about an axis separate from its central axis; and wherein the forcing step comprises simultaneously executing at least two of the rotation of the forcing member (91) about its central axis, the revolution of the forcing member (91) about the axis separate from its central axis, and linear motion of the forcing member (91).

3. A method as recited in claim 1, wherein the hole (24) in the substrate (23) has a closed bottom.

4. A method as recited in claim 1, wherein the substrate (23) comprises an insulating substrate (23), and the hole (24) comprises a via hole (24) in the insulating substrate (23).

5. method as recited in claim 4, wherein the insulating substrate (23) has a surface formed with a conductor pattern (22), and the via hole (24) has a bottom closed by the conductor pattern (22).

6. A method as recited in claim 4, wherein the fluid material (50) comprises electrically conductive paste (50).

7. A method of manufacturing a multi-layer printed circuit board (100) comprising:
preparing a plurality of conductor-pattern films (21);
laminating the conductor-pattern films (21); and
connecting conductor patterns (22) on both sides of one of the conductor-pattern films (21) via a conductive material (50) filled in a via hole (24) on the conductor-pattern film (21),
wherein the preparing of one of the conductor-pattern films (21) comprising:
forming the via hole (24) in a film (23);
placing the film (23) on a table (3);
placing a forcing member (91) so that a surface of the forcing member (91) faces the surface of the film (23);
supplying the conductive material (50) from an opening located approximately in a center of the forcing member (91) to between the surface of the forcing member (91) and the surface of the film (23); and
holding the conductive material in recesses (94) of the surface of the forcing member (91), moving the fluid material (50) from the recesses (94) of the surface of the forcing member (91) into the via hole (24) by rotating the forcing member (91) about an axis perpendicular to the surface of the substrate (23), and moving the axis of rotation of the forcing member (91) along the surface of the substrate (23) to force the conductive material (50) into the via hole (24) along at least three different directions on the surface of the substrate (23).

8. The method as recited in claim 7, wherein the rotating motion is performed by rotating the forcing member (91) about an axis on the center of the forcing member (91).

9. The method as recited in claims 7, wherein the rotating motion is performed by moving the forcing member (91) along an axis separate from its central axis.

10. The method as recited in claim 7, further comprising forming a conductor pattern (22) on the film (23) prior to the forming of the via hole (24), the conductor pattern (22) being formed on the film (23) to close one end of the via hole (24).

11. The method as recited in claim 7, further comprising protecting the surface of the film (23) with a protective film (81) during forming one of the conductor pattern films (21).

12. The method as recited in claims 1 or 7, wherein the forcing member (91) comprises an urethane foam resin pad member.

## Patentansprüche

1. Verfahren zum Beladen eines Loches (24) in einem Substrat (23) mit einem Fluidmaterial (50), das die folgenden Schritte aufweist:
Platzieren eines Druckelementes (91), das eine Oberfläche aufweist, die Einschnitte (94) und eine Öffnung aufweist, die näherungsweise in deren Mitte angeordnet ist und durch die Fluidmaterial (50) derart zugeführt wird, dass die Oberfläche des Druckelements (91) dem Substrat (23) gegenüberliegt;
Zuführen des Fluidmaterials (50) zwischen die Oberfläche des Druckelements (91) und eine Oberfläche des Substrats (23); und
Halten des Fluidmaterials (50) in den Einschnitten (94) der Oberfläche des Druckelements (91), Bewegen des Fluidmaterials (50) von den Einschnitten (94) der Oberfläche des Druckelements (91) in das Loch (24) durch Drehen des Druckelements (91) um eine Achse senkrecht zur Oberfläche des Substrats (23), und Bewegen der Achse der Drehung des Druckelements (91) entlang der Oberfläche des Substrats (23), um das Fluidmaterial (50) in das Loch (24) entlang zumindest drei unterschiedlichen Richtungen auf der Oberfläche des Substrats (23) zu drücken.

2. Verfahren nach Anspruch 1, wobei die Drehung des Druckelements (91) eine Drehung des Druckelements (91) um seine Mittelachse und eine Drehung des Druckelements (91) um eine von der Mittelachse getrennte Achse aufweist; und wobei der Schritt des Drückens aufweist:
Gleichzeitiges Ausführen zumindest zwei der folgenden Bewegungen: Drehung des Druckelements (91) um dessen Mittelachse, Drehung des Druckelements (91) um die von der Mittelachse getrennten Achse, und lineare Bewegung des Druckelements (91).

3. Verfahren nach Anspruch 1, wobei das Loch (24) in dem Substrat (23) einen geschlossenen Boden aufweist.

4. Verfahren nach Anspruch 1, wobei das Substrat (23) ein Isoliersubstrat (23) aufweist und das Loch (24) ein Durchgangsloch (24) in dem Isoliersubstrat (23) aufweist.

5. Verfahren nach Anspruch 4, wobei das Isoliersubstrat (23) eine Oberfläche aufweist, die mit einem Leitermuster (22) versehen ist, und das Durchgangsloch (24) einen Boden aufweist, der durch das Leitermuster (22) geschlossen ist.

6. Verfahren nach Anspruch 4, wobei das Fluidmaterial (50) eine elektrisch leitende Paste (50) aufweist.

7. Verfahren zum Herstellen einer mehrschichtigen gedruckten Leiterplatte (100), das aufweist:
Vorbereiten mehrerer Leitermusterfilme (21);
Schichten der Leitermusterfilme (21); und
Verbinden der Leitermuster (22) an beiden Seiten eines der Leitermusterfilme (21) durch ein leitendes Material (50), das in ein Durchgangsloch (24) auf dem Leitermusterfilm (21) gefüllt ist, miteinander,
wobei das Vorbereiten eines der Leitermusterfilme (21) aufweist:
Ausbilden des Durchgangslochs (24) in einem Film (23);
Platzieren des Films (23) auf einer Platte (3);
Platzieren eines Druckelements (91) derart, dass eine Oberfläche des Druckelements (91) der Oberfläche des Films (23) gegenüberliegt;
Zuführen des leitenden Materials (50) von einer Öffnung, die näherungsweise in der Mitte des Druckelements (91) angeordnet ist, zwischen die Oberfläche des Druckelements (91) und die Oberfläche des Films (23); und
Halten des leitenden Materials in Einschnitten (94) der Oberfläche des Druckelementes (91), Bewegen des Fluidmaterials (50) von den Einschnitten (94) der Oberfläche des Druckelements (91) in das Durchgangsloch (24) durch Drehen des Druckelements (91) um eine Achse senkrecht zur Oberfläche des Substrats (23), und Bewegen der Achse der Drehung des Druckelements (91) entlang der Oberfläche des Substrats (23), um das leitende Material (50) in das Durchgangsloch (24) entlang zumindest drei unterschiedlichen Richtungen auf der Oberfläche des Substrats (23) zu drücken.

8. Verfahren nach Anspruch 7, wobei die Drehbewegung durch Drehen des Druckelements (91) um eine Achse auf der Mitte des Druckelements (91) durchgeführt wird.

9. Verfahren nach Anspruch 7, wobei die Drehbewegung durch Bewegung des Druckelements (91) entlang einer von der Mittelachse getrennten Achse durchgeführt wird.

10. Verfahren nach Anspruch 7, das außerdem aufweist:
Ausbilden eines Leitermusters (22) auf dem Film (23) vor dem Ausbilden des Durchgangslochs (24), wobei das Leitermuster (22) auf dem Film (23) ausgebildet wird, um eine Ende des Durchgangslochs (24) zu schließen.

11. Verfahren nach Anspruch 7, das außerdem aufweist:
Schützen der Oberfläche des Films (23) mit einem Schutzfilm (81) während des Ausbildens eines der Leitermusterfilme (21).

12. Verfahren nach Anspruch 1 oder 7, wobei das Druckelement (91) ein Kissenelement aus Urethanschaumharz aufweist.

## Revendications

1. Procédé de chargement d'un trou (24) dans un substrat (23) avec un matériau fluide (50), comprenant les étapes consistant à :
placer un élément forçant (91) ayant une surface qui a des évidements (94) et une ouverture située approximativement au centre de celui-ci à travers laquelle le matériau fluide (50) est amené de sorte que la surface de l'élément forçant (91) soit face au substrat (23) ;
amener le matériau fluide (50) entre la surface de l'élément forçant (91) et une surface du substrat (23) ; et
maintenir le matériau fluide (50) dans les évidements (94) de la surface de l'élément forçant (91), déplacer le matériau fluide (50) depuis les évidements (94) de la surface de l'élément forçant (91) dans le trou (24) en faisant tourner l'élément forçant (91) autour d'un axe perpendiculaire à la surface du substrat (23), et déplacer l'axe de rotation de l'élément forçant (91) le long de la surface du substrat (23) pour forcer le matériau fluide (50) dans le trou (24) le long d'au moins trois directions différentes sur la surface du substrat (23).

2. Procédé selon la revendication 1, dans lequel la rotation de l'élément forçant (91) comprend l'une parmi la rotation de l'élément forçant (91) autour de son axe central et la révolution de l'élément forçant (91) autour d'un axe séparé de son axe central ; et dans lequel l'étape de forçage comprend l'exécution simultanée d'au moins deux parmi la rotation de l'élément forçant (91) autour de son axe central, la révolution de l'élément forçant (91) autour de l'axe séparé de son axe central et le déplacement linéaire de l'élément forçant (91).

3. Procédé selon la revendication 1, dans lequel le trou (24) dans le substrat (23) a un fond fermé.

4. Procédé selon la revendication 1, dans lequel le substrat (23) comprend un substrat isolant (23) et le trou (24) comprend un trou de passage (24) dans le substrat isolant (23).

5. Procédé selon la revendication 4, dans lequel le substrat isolant (23) a une surface formée avec un motif conducteur (22) et le trou de passage (24) a un fond fermé par le motif conducteur (22).

6. Procédé selon la revendication 4, dans lequel le matériau fluide (50) comprend une pâte électriquement conductrice (50).

7. Procédé de fabrication d'une carte de circuit imprimé multicouche (100) comprenant les étapes consistant à :
préparer une pluralité de films de motif conducteur (21) ;
laminer les films de motif conducteur (21) ; et
connecter les motifs conducteurs (22) sur les deux face d'un des films de motif conducteur (21) par l'intermédiaire d'un matériau conducteur (50) chargé dans un trou de passage (24) sur le film de motif conducteur (21),
dans lequel la préparation d'un des films de motif conducteur (21) comprend les étapes consistant à :
former le trou de passage (24) dans un film (23) ;
placer le film (23) sur une table (3) ;
placer un élément forçant (91) de sorte qu'une surface de l'élément forçant (91) soit face à la surface du film (23) ;
amener le matériau conducteur (50) depuis une ouverture située approximativement au centre de l'élément forçant (91) entre la surface de l'élément forçant (91) et la surface du film (23) ; et
maintenir le matériau conducteur dans les évidements (94) de la surface de l'élément forçant (91), déplacer le matériau fluide (50) depuis les évidements (94) de la surface de l'élément forçant (91) dans le trou de passage (24) par rotation de l'élément forçant (91) autour d'un axe perpendiculaire à la surface du substrat (23), et déplacer l'axe de rotation de l'élément forçant (91) le long de la surface du substrat (23) pour forcer le matériau conducteur (50) dans le trou de passage (24) le long d'au moins trois directions différentes sur la surface du substrat (23).

8. Procédé selon la revendication 7, dans lequel le mouvement de rotation est effectué par rotation de l'élément forçant (91) autour d'un axe au centre de l'élément forçant (91).

9. Procédé selon la revendication 7, dans lequel le mouvement de rotation est effectué en déplaçant l'élément forçant (91) le long d'un axe séparé de son axe central.

10. Procédé selon la revendication 7, comprenant en outre la formation d'un motif conducteur (22) sur le film (23) avant la formation du trou de passage (24), le motif conducteur (22) étant formé sur le film (23) pour fermer une extrémité du trou de passage (24).

11. Procédé selon la revendication 7, comprenant en outre la protection de la surface du film (23) avec un film protecteur (81) durant la formation d'un des films de motif conducteur (21).

12. Procédé selon la revendication 1 ou 7, dans lequel l'élément forçant (91) comprend un élément de tampon de résine de mousse uréthane.
